# EUROPEAN PATENT APPLICATION

(11) **EP 0 520 482 A2**
(43) Date of publication of application: **30.12.1992**
(21) Application number: 92110795.9
(22) Date of filing: 26.06.1992
(51) Int. Cl.: H01L 29/08, H01L 29/73, H01L 21/331

(54) **Multiple layer collector structure for bipolar transistors**

(30) Priority: 28.06.1991 US 723111; 28.06.1991 US 722984
(71) Applicant: TEXAS INSTRUMENTS INCORPORATED, Dallas Texas 75265 (US)
(72) Inventor: Liu, William Uei-Chung, Dallas, Texas 75243 (US); Hill, Darrell G., Plano, Texas 75075 (US)
(74) Representative: Leiser, Gottfried, Dipl.-Ing.

(57) **Abstract**

Generally, and in one form of the invention, a multiple layer collector structure is provided which comprises a relatively thin, highly doped layer 12 and a relatively thick, low doped or non-intentionally doped layer 14.

## Description

### FIELD OF THE INVENTION

This invention generally relates to a multiple layer collector structure for bipolar transistors.

### BACKGROUND OF THE INVENTION

Without limiting the scope of the invention, its background is described in connection with heterojunction bipolar transistors (HBTs), as an example.

Heretofore, in this field, two of the most important figures of merit in power HBT design have been the emitter-collector breakdown voltage, BV_{ceo}, and the maximum operating current density prior to base pushout, Jₘₐₓ. For a transistor under a given bias condition, its output power is directly proportional to the product of the operating emitter-collector voltage and the collector current density. Therefore, one would like to design a power transistor to operate at large emitter-collector voltage and collector current density. However, when the emitter-collector voltage is increased to an extreme, the base-collector junction breakdown eventually occurs and the transistor ceases to operate. The voltage at which the breakdown occurs is essentially the emitter-collector breakdown voltage, BV_{ceo}.

On the other hand, power can also be increased by increasing the operating collector current density level. As with the case of increasing emitter-collector voltage, there is a limit to the operating collector current density level, Jₘₐₓ, beyond which the transistor ceases to function properly. The physical effect imposing this limit of current density level is called the base pushout effect (also known as the Kirk effect). When the operating collector current density is larger then Jₘₐₓ, the number of free carriers entering the base-collector space-charge region becomes so large that the carriers greatly modify the background charge in that region. Consequently, the electric field at the base side of the base-collector junction decreases to zero, and the base majority carriers spill over into the junction. At this point, the effective base width suddenly increases and current gain dramatically decreases, causing the transistor to cease to function properly.

In practice, both of these parameters are heavily influenced by the design of the collector, which can be varied in both thickness and doping concentration. The collector thickness of an HBT designed for high power applications is generally required to be as thick as possible, so that a large reverse base-collector junction voltage can be sustained. However, when carried to an extreme, the collector space charge transit time becomes so large that the transistor cannot effectively function at frequencies of interest. As the thickness of the collector is increased, the time required for carriers to cross the collector (known as the collector space charge transit time, or collector transit time) also increases. When the collector transit time becomes a substantial fraction of one period or cycle at the frequency of operation, the current gain and efficiency of the transistor are drastically reduced at that frequency. With a thicker collector, a larger reverse base-collector junction voltage can be sustained and, therefore, BV_{ceo} becomes larger. Typically, for HBTs designed for X-band operation (6.2 GHz - 10.9 GHz), the collector thickness is constrained to 1 µm or less. Consequently, the breakdown voltage is limited to a certain value determined by the material properties of the collector, such as the maximum breakdown electric field. In the case of a GaAs collector, the maximum attainable emitter collector breakdown voltage BV_{ceo}, is roughly 24V. The only remaining design option is thus the collector doping. With only this one design parameter to work with, the collector doping profile must be a tradeoff between the maximization of BV_{ceo} or Jₘₐₓ. At one extreme, it is desired to make this collector doping level, N_{coll}, as heavy as possible so that the base pushout effects start at a much higher current density, given as:

${\text{J}}_{\text{max}} {\text{= q x N}}_{\text{coll}} {\text{x V}}_{\text{sat}}$

where:
q is the electronic charge
Vₛₐₜ is the saturation velocity of the carriers
Consequently, Jₘₐₓ is large and the transistor can be operated at higher current levels.

At the other extreme, it is desired to make the collector doping profile as light as possible, so that a higher voltage can be sustained across the base-collector junction before the junction breakdown occurs. In this manner, BV_{ceo} can be increased, and the transistor can be operated at higher voltages.

Therefore, a problem faced with the conventional single-layer collector, for example, a GaAs collector has been that there is virtually no design freedom for the substantially independent and simultaneous increase of both BV_{ceo} and Jₘₐₓ by varying just the collector doping level. Another problem faced has been that the maximum attainable BV_{ceo} has been limited to roughly 24V. Accordingly, improvements which overcome this problem are presently desirable.

### SUMMARY OF THE INVENTION

It is herein recognized that a need exists for a bipolar transistor with more independent control of Jₘₐₓ and BV_{ceo}. The present invention is directed towards meeting those needs.

Generally, and in one form of the invention, a multiple layer collector structure is provided which comprises a relatively thin, highly doped layer and a relatively thick, low doped or non-intentionally doped layer.

In another form of the invention, there is provided a high power bipolar transistor comprising a substrate, a subcollector layer on the substrate, a relatively thick and low doped or and non-intentionally doped first collector layer on the subcollector, a relatively thin and highly doped second collector layer on the first collector layer, a base layer on the second collector layer, and an emitter layer on the base layer.

In yet another form of the invention, there is provided a method for making a multiple layer collector structure comprising the steps of forming a relatively thick and low doped or non-intentionally doped layer and depositing a relatively thin and highly doped layer on the low doped or non-intentionally doped layer.

In still another form of the invention, a method for making a high power bipolar transistor is provided, comprising the steps of forming a substrate, depositing a subcollector layer on the substrate, depositing a first collector layer on the subcollector, the first collector layer being relatively thick and low doped or non-intentionally doped, depositing a second collector layer on the first collector layer, the second collector layer being relatively thin and highly doped, depositing a base layer on the second collector layer, and depositing an emitter layer on the base layer.

An advantage of the invention is that it allows for relatively independent control of Jₘₐₓ and BV_{ceo} in a bipolar transistor.

### BRIEF DESCRIPTION OF THE DRAWINGS

The foregoing and further aspects of the invention are illustrated, by way of example, in the accompanying drawings wherein like elements are denoted by like reference designators and in which:
FIG. 1 is a schematic view of a first preferred embodiment of the present invention;
FIG. 2 is a data plot of computer simulated values of Jₘₐₓ and BV_{ceo} for devices incorporating the collector structures of Table I;
FIG. 3A-3E is a cross-sectional view showing the steps of a second preferred embodiment fabrication process of the present invention;
FIG. 4 is a schematic view of a third preferred embodiment of the present invention.

### DETAILED DESCRIPTION OF PREFERRED EMBODIMENTS

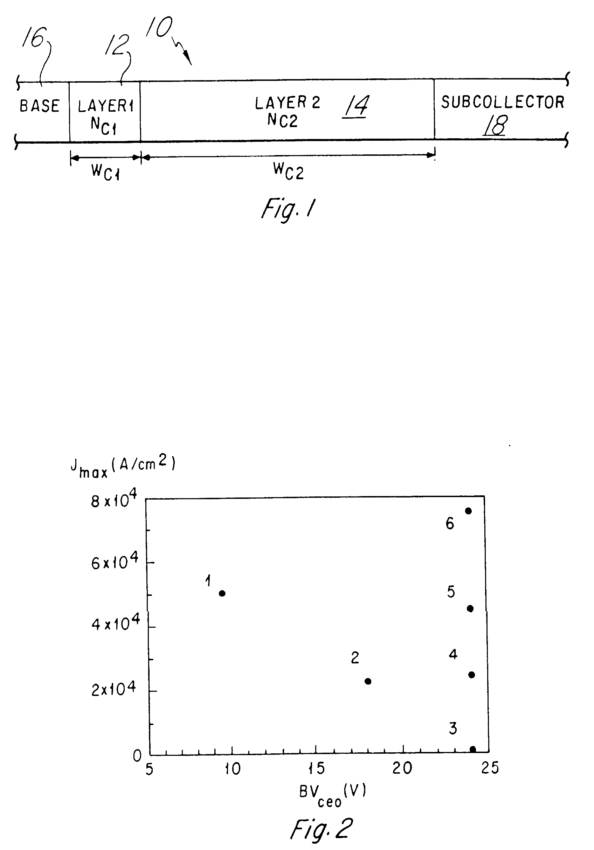

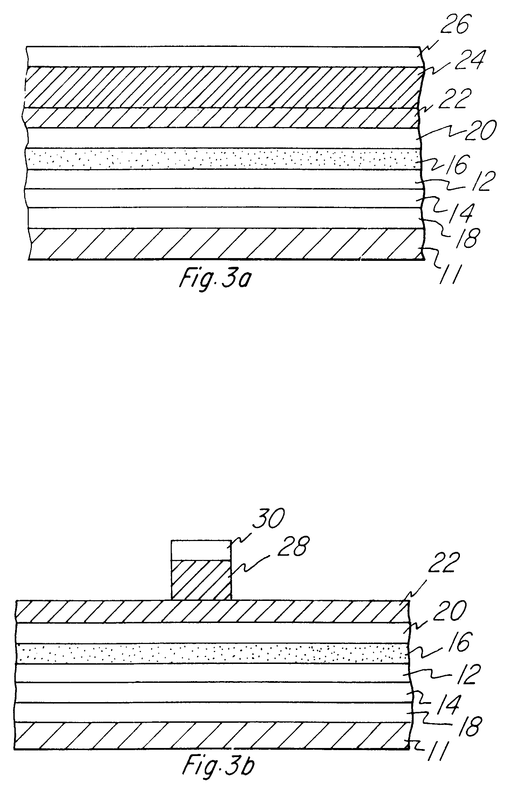

With reference to Figure 1, a first preferred embodiment of the present invention is described hereinbelow which solves the dilemma of choosing between mutually exclusive collector doping profiles in attempting to maximize the values of BV_{ceo} and Jₘₐₓ by utilizing a novel two-layer collector structure.

The first preferred embodiment of the present invention is comprised of a transistor indicated generally at 10, having a collector composed of two distinct layers 12 and 14. The first collector layer 12 is disposed next to a base 16, the second collector layer 14 is disposed between the rust collector layer 12 and a subcollector 18 or a graded layer 17. The first collector layer may be composed of AlₓGa₁₋ₓAs, with the aluminium composition graded from 0% at the junction with the base 16 to 100%, for example, at the junction with the second collector layer 14. The first collector layer 12 has a width (measured in the direction of current flow) W_{C1} of about 400 Angstroms, for example, and is doped at a relatively high concentration level N_{C1}, such as 1x10¹⁸ atoms/cm³. The second collector layer 14 may also be composed of AlₓGa₁₋ₓAs, but has a uniform aluminium composition of 100%, for example, (AlAs is used as an example since the bandgap of AlₓGa₁₋ₓAs is highest at this particular composition. However, this design is completely general, and the aluminium composition is not restricted to 100%). The second collector layer 14 has a width (measured in the direction of current flow) W_{C2} of about 1 µm, for example, and does not have any intentional doping N_{C2}. If the graded layer 17 is employed it may be made of AlₓGa₁₋ₓAs with a 100% aluminium composition (AlAs), for example, at the interface with collector layer 14, decreasing to 0% (GaAs) at the interface with the subcollector 18. The graded layer 17 is preferably about 300 Å thick and doped with Si to a concentration of approximately 5x10¹⁸ cm⁻³. The exact doped concentration of layer 17 is not critical since it is not part of the active collector layer (layers 12 and 14). A relatively high doping concentration will make the extra (though small) resistance associated with this layer 17 negligible.

The first collector layer 12, which is adjacent to the base 16, is doped heavily, but its width W_{C1} must be thin enough so that this layer is depleted, preferably even at zero external base-collector bias. This is because during the operation of a high frequency power bipolar transistor, the base-emitter bias is continuously varied from zero to a value limited by BV_{ceo}. If during any part of the cycle the collector is not fully depleted, part of the power will be dissipated in the undepleted portion of the collector, which constitutes essentially a parasitic collector resistance.
Consequently, if the collector can be fully depleted even at zero bias, then there will be no parasitic power dissipation associated with the collector at any given bias condition. The purpose of this thin, heavily doped layer 12 is to create a large magnitude of electric field in the junction area close to the base layer 16. This large field prevents the base pushout effects from occurring at lower current levels and, consequently, Jₘₐₓ increases.

When a carrier travels in a base-collector junction, it travels, on average, a "mean free path", before interacting with an atom in the lattice and losing its energy. However, if the emitter-collector bias increases toward BV_{ceo}, the electric field in the junction becomes large. Consequently, the carrier can gain sufficient energy from the field while traveling within its mean free path, such that it breaks the bond between the atom core and one of the bound electrons upon impacting the lattice. The initial carrier, as well as the hole and electron created by the collision are then free to leave the region of the collision. This process is called impact ionization. When the emitter-collector bias is larger than BV_{ceo}, the events of impact ionization are so numerous that the collector current due to the ionized carrier becomes infinitely large and the transistor ceases to function properly. At this point, the transistor is said to reach the emitter-collector breakdown condition. It should be noted that carriers in GaAs, for example, must acquire a threshold energy of 1.7 eV before impact ionization can occur. Therefore, it is important that the first collector layer 12 be made thin (i.e. small W_{C1}) so that even when carriers traverse this high field region, the amount of energy the carriers pick up from the electric field is below 1.7 eV and therefore they have not acquired enough energy to cause avalanche breakdown. With this design principle, most of the impact ionizations actually occur in the second collector layer 14, rather than in the high field region of the first collector layer 12. Consequently, it is desirable that the second collector layer 14 be made thick (i.e. large W_{C2}) and lightly doped (i.e. small N_{C2}) so that it will sustain a large voltage drop before the junction breakdown occurs. Therefore, BV_{ceo} increases.

The fact that avalanche breakdown initiates from this low field second collector layer 14 has been verified with a computer simulation which utilizes the most recent electron and hole impact ionization coefficients. It has been calculated that, despite the fact that the first collector layer 12 is a high field region, it only contributes approximately 5% of the impact ionizations at the onset of avalanche breakdown. Consequently, to increase the breakdown voltage BV_{ceo} even further, the second collector layer 14 may be made of AlₓGa₁₋ₓAs, which can sustain a higher voltage drop before avalanche breakdown occurs due to its larger bandgap compared to GaAs. The breakdown voltage BV_{ceo} is approximately proportional to the 3/2 power of the bandgap. For a 1µm GaAs collector structure, the BV_{ceo} is calculated to be 24V. On the other hand, with the use of Al_{1.00}Ga_{0.00}As in the second collector layer 14, the BV_{ceo} is expected to reach 44.4V, which is nearly a 185% increase.

It is not necessary to have the first collector layer 12 be composed of AlₓGa₁₋ₓAS since the major portion of the impact ionization contributing to the eventual avalanche breakdown originates from the second collector layer 14. In fact, the first collector layer 12 is graded so that an abrupt band discontinuity does not exist at the base-collector junction. The undesirable effects of quantum reflection and dramatic carrier collection reduction associated with an abrupt junction thus do not appear. In addition, this first layer is sufficiently thin so that the entire collector is fully depleted, even at zero external base-collector bias. Its thickness W_{C1} is thus typically between about 200Å and about 500Å, which, fortuitously, is the grading distance required for typical epitaxial growth techniques when the graded layer is utilised.

It can therefore be seen that with the first preferred embodiment of the invention, Jₘₐₓ can be increased by heavily doping a thin collector layer 12 adjacent to the base 16, while BV_{ceo} can also be increased by simply inserting a thick, unintentionally doped collector layer 14 between the first collector layer 12 and the subcollector 18. Both Jₘₐₓ and BV_{ceo} can thus essentially be simultaneously and independently increased, without any trade off.

Figure 2 illustrates the results of a computer simulation program used to calculate Jₘₐₓ and BV_{ceo} for the various device structures listed in Table I (the numbered points on the graph of Figure 2 correspond to the device numbers of Table I).

**Table I**

| Device | N_{C1} | W_{C1} | N_{C2} | W_{C2} |
|---|---|---|---|---|
| 1 | 5x10¹⁶ | 1 µm | | |
| 2 | 2x10¹⁶ | 1 µm | | |
| 3 | 1x10¹⁴ | 1 µm | | |
| 4 | 1x10¹⁷ | 1000 Å | 1x10¹⁴ | 1 µm |
| 5 | 5x10¹⁷ | 500 Å | 1x10¹⁴ | 1 µm |
| 6 | 1x10¹⁸ | 400 Å | 1x10¹⁴ | 1 µm |

The software used to run the simulation was implemented with accurate base pushout analyses and avalanche coefficients for electrons and holes in GaAs. Preliminary experimentation correlates well with the program calculations. It is readily evident from the first three data points plotted in Figure 2, which represent the performance of a standard one-layer collector structure as shown in Table I, that there is an almost perfect inverse relationship between Jₘₐₓ and BV_{ceo} for these devices. By contrast, data points 4, 5 and 6, which represent the performance of devices constructed according to the first preferred embodiment of the present invention as shown in Table I, illustrate that Jₘₐₓ can substantially be increased independent of any effect on BV_{ceo}, by simply changing the thickness W_{C1} and the doping concentration N_{C1} of the first collector layer 12. Additionally, a sensitivity analysis has been performed which shows that for HBTs designed for X-band applications in which the collector thickness W_{C2} is limited to 1 µm, the unintentionally doped second collector layer 14 can have a doping concentration N_{C2} as high as 1x10¹⁶ atoms/cm³ (donor or acceptor) before a sudden drop of BV_{ceo} takes place. Since growth techniques such as, for example, molecular beam epitaxy (MBE) and metal organic chemical vapor deposition (MOCVD) can reproducibly grow unintentionally doped layers at doping concentrations below 1x10¹⁵ atoms/cm³, and often achieving a concentration of 1x10¹⁴ atoms/cm³, the proposed structure of the first preferred embodiment of the present invention can be practically fabricated.

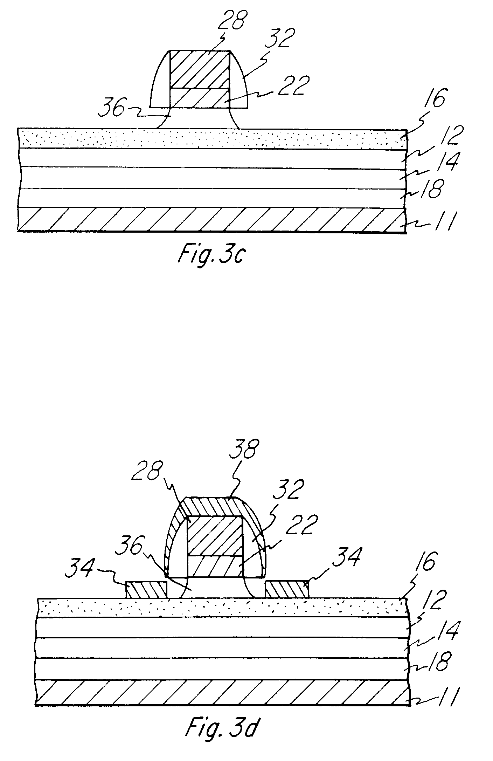

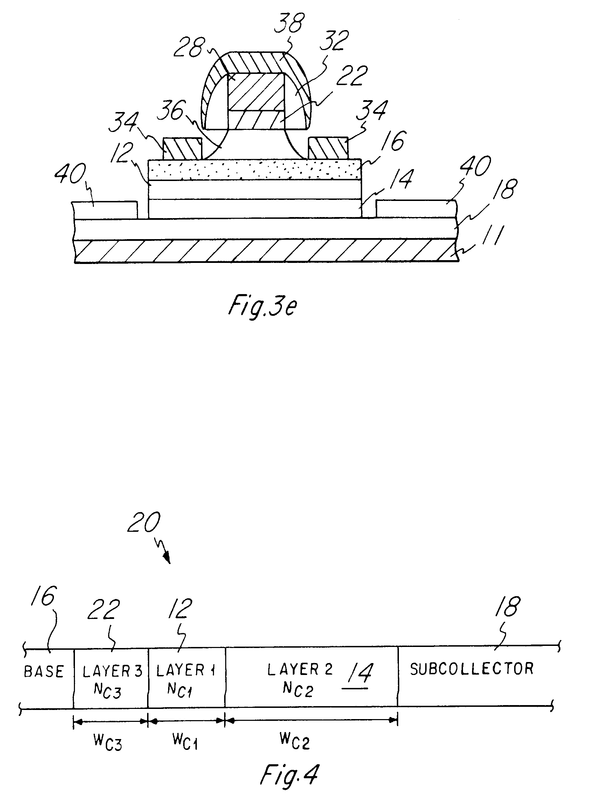

The method for fabricating a second preferred embodiment of the present invention includes the following steps as illustrated in cross sectional elevation views in Figures 3A-3E. It incorporates a heterojunction bipolar transistor (HBT) design that is described in copending application serial number 07/576,540, which is incorporated herein by reference. Although the second preferred embodiment is illustrated with a heterojunction device, the present invention may be practiced with any bipolar structure.
(a) A substrate material for this process is shown in Figure 3A; note that the vertical is exaggerated in the drawings for clarity. It is composed of a semi-insulating semiconductor material 11 (such as GaAs) of (100) orientation.
(b) a subcollector layer 18 of n-type GaAs, for example, is epitaxially grown on the substrate 11 by a suitable process (such as Metal Organic Chemical Vapor Deposition, or MOCVD) to a thickness of 1 micron and doped with Si to a concentration of approximately 5x10¹⁸ cm⁻³. An AlₓGa₁₋ₓAs graded layer 17 may next be epitaxially grown on top of subcollector 18. The thickness of layer 17 is typically about 300 Å, and the aluminium composition is graded from 0% (GaAs) at the subcollector 18 interface to, for example, 100% (AlAs) at the opposite end (i.e. if AlAs is the chosen material for collector layer 14). The doping of this layer is also with Si to a concentration of approximately 5x10¹⁸ cm⁻³.
(c) a collector layer 14 is epitaxially grown on subcollector layer 18 to a thickness of 1 µm and is preferably made of GaAs or AlAs, for example. The doping of layer 14 is preferrably unintentional and as low as possible (∼10¹⁴ cm⁻³). However, as mentioned previously, sensitivity analysis indicates that a doping as high as_10¹⁶ cm⁻³ is tolerable. A second collector layer 12 is epitaxially grown on collector layer 14 and is also preferably of GaAs or is of graded AlₓGa₁₋ₓAs with aluminium composition varying from 100% (AlAs) at the collector 14 interface to 0% (GaAs) at the opposite end. Layer 12 is grown to a thickness of approximately 400Å and is doped with Si, for example, to approximately 1x10¹⁸cm⁻³.
(d) a base epilayer 16 of GaAs, for example, is deposited onto collector layer 12 to a thickness of 0.08µm and doped with C, for example, to a concentration of approximately _3x10¹⁹ cm⁻³. Emitter epilayer 20 of n-type AlₓGa₁₋ₓAs is then deposited onto base layer 16 at a thickness of 0.05 micron by epitaxy. Next, 500 Angstrom thick AuGe emitter ohmic contact metal, followed by 140 Angstrom Ni and 2000 Angstrom Au layers are evaporated onto the surface. Insulator layer 28 is then formed of a suitable material (such as SiO₂ or Si₃N₄) at a thickness of 4000 Angstroms by chemical vapor deposition (CVD). A photoresist 30 is then spun on the previous layers and patterned to define the location of the HBT emitters. The emitter locating insulator islands 28 are then created by a reactive ion etch (RIE) of the insulator material not protected by the photoresist using CF₄ and O₂. Photoresist 30 may optionally be removed alter RIE. This yields the structure of Figure 3B.
(e) Ohmic contact layer 22 is then removed from areas not protected by the insulator islands 28 by ion milling using Ar, preferably at a 30^{o} angle to minimize backsputtering, creating emitter contact 22. Photoresist 26 is then stripped if not done so previously. Sidewalls 32 are formed by depositing a 4000 Angstrom Si₃N₄ (or SiO₂) layer over the entire surface using CVD techniques.This assures an isotropic coverage. The insulator is then etched in low pressure (about 10-20 mTorr) CF₄/O₂ RIE, making sure that the etch is anisotropic. The etch is continued until all of the insulator material on the flat wafer surface is removed. Due to the anisotropic nature of the etch, a portion of the insulator material remains along the edges of insulator islands 24 and emitter contacts 22 as shown in Figure 3C. Next, the areas of emitter epilayer 20 that are not protected by insulator islands 28 and sidewalls 32 are chemically etched down to base epilayer 16 in, for example, a solution of H₂SO₄:H₂O₂:H₂O in the ratio of 1:8:160 (by volume) as shown in Figure 3C.
(f) Photoresist is again spun on and patterned to define the location of the base contacts 34; this exposes insulator islands 28 and sidewalls 32 in addition to a portion of the base epilayer 16. Ti/Pt/Au metals are evaporated in sequence at thicknesses of 500, 250 and 1500 Angstroms, respectively, onto the photoresist and exposed areas. The overhanging sidewalls 32 shadow the part of the base epilayer 16 adjacent to emitter 36, so the evaporated metal does not contact emitter 36. The photoresist is then removed which lifts off the metal except the portion 34 which is on the base epilayer 16 and the portion 38 which is on insulator island 28 and sidewalls 32. See Figure 3D.
(g) A photoresist mask (not shown) is then deposited and patterned to define the connection to the subcollector layer 18. Layers 16, 12 and 14 are then etched using a solution of H₂SO₄:H₂O₂:H₂O in the ratio of 1:8:160 (by volume), for example. Afterwards, AuGe/Ni/Au metals are evaporated onto the wafer to thicknesses of 500/140/2000 Å, respectively, to form the collector contact 40. Then photoresist layer is then stripped, which lifts off all excess metallization.

The most important design criterion for the relatively independent control of Jₘₐₓ and BV_{ceo} is the formation of a first thin high-field region adjacent to a base and a second thick low-field region between the first region and the subcollector. The thickness of the first region should be such that the energy acquired by carriers traversing through the layer is less than the energy required for impact ionization in the material. As demonstrated, this is readily achieved with the device of the first preferred embodiment of the invention.

However, other structures potentially can achieve the same electric field profile. For example, a third preferred embodiment of the present invention is illustrated in Figure 4 which meets this criterion. The third preferred embodiment of the present invention is comprised of a transistor indicated generally at 20, which is identical to the device of the first preferred embodiment of the present invention with the addition of a third collector layer 22 inserted between the base 16 and the first collector layer 12. The third collector layer 22 has a width (measured in the direction of current flow) W_{C3} of 300 Angstroms, for example, and is doped at a relatively low concentration level N_{C3}, such as 10¹⁴ atoms/cm³. To achieve maximum BV_{ceo}, layers 12 and 14 are preferably made of AlAs and layer 22 is preferably made of graded AlGaAs, with the aluminium composition varying from 100% (AlAs) at the interface with layer 12 to 0% (GaAs) at the interface with the base layer 16. Additionally, it is possible to let layer 12 remain as graded AlGaAs (as in the first preferred embodiment) and layer 22 be pure GaAs. Since this three-layer collector structure results in essentially the same electric field profile as the two-layer structure of the first preferred embodiment of the present invention, it will also allow substantially independent control of Jₘₐₓ and BV_{ceo}.

An additional and important advantage of the present invention is that it will greatly reduce or eliminate the change in base-collector capacitance of a transistor in response to the base-collector bias. This change in capacitance can cause parametric oscillations and other problems in a bipolar transistor amplifier output.

A few preferred embodiments have been described in detail hereinabove. It is to be understood that the scope of the invention also comprehends embodiments different from those described, yet within the scope of the claims. For example, GaAs and AlGaAs has been used throughout the specification by way of illustration only. It will be obvious to those skilled in the art that the present invention may be practiced with any semiconductor material as a mere design choice.

Words of inclusion are to be interpreted as nonexhaustive in considering the scope of the invention.

Internal and external connections can be ohmic, capacitive, direct or indirect, via intervening circuits or otherwise. Implementation is contemplated in discrete components or fully integrated circuits in silicon, gallium arsenide, or other electronic materials families, as well as in optical-based or other technology-based forms and embodiments.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description. It is therefore intended that the appended claims encompass any such modifications or embodiments.

## Claims

1. A device comprising a multiple layer collector structure, said collector structure comprising:
a relatively thick, low doped or non-intentionally doped first collector layer; and
a relatively thin, highly doped second collector layer.

2. The device of Claim 1 wherein said collector structure is part of a heterojunction bipolar transistor (HBT).

3. The device of any preceding claim further comprising:
a substrate;
a subcollector layer disposed on said substrate;
a base layer disposed on said second collector layer; and
an emitter layer disposed on said base layer; and wherein said first collector layer is disposed on said subcollector layer, and
said second collector layer is disposed on said first collector layer,

4. The device of any of claims 1 to 3, wherein said layers are of GaAs.

5. The device of any of claims 1 to 3, wherein said first collector layer is AlₓGa₁₋ₓAs and said highly doped layer is AlₓGa₁₋ₓAs.

6. The device of any preceding claim, wherein said second collector layer is thin enough to prevent energy acquired by a majority of carriers traversing said second collector layer from being greater than the energy required for impact ionization in said layer.

7. The device of any preceding claim, wherein said second collector layer is fully depleted at a majority of base-collector bias voltages between zero and BV_{ceo}.

8. The device of any preceding claim, wherein said first collector layer has a dopant concentration of <1x10¹⁶ atoms/cm³.

9. The device of any preceding claim, wherein said second collector layer has a dopant concentration of >1x10¹⁷ atoms/cm³.

10. The device of Claim 3 or any of Claims 4 to 9 when dependant on Claim 3, wherein said emitter layer is made of semiconductor material having a wider energy bandgap than said base layer.

11. The device of any of Claim 3 or any of Claims 4 to 10 when dependant on Claim 3, wherein said second collector layer has a graded semiconductor composition in order to prevent the formation of a heterojunction between the first collector layer and said base layer.

12. The device of any preceding claim, wherein the multi layer collector is a wide bandgap collector.

13. A method for making a multiple layer collector structure for bipolar transistors, comprising the steps of:
forming a relatively thick, low doped or non-intentionally doped layer; and
depositing a relatively thin, highly doped layer on said low doped or non-intentionally doped layer.

14. The method of Claim 13, further comprising the step of depositing said highly doped layer thin enough to prevent energy acquired by a majority of carriers traversing said layer from being greater than the energy required for impact ionization in said layer.

15. The method of Claim 13 or Claim 14, further comprising the step of doping said highly doped layer to be fully depleted at a majority of base-collector bias voltages between zero and BV_{ceo}.

16. The method of any of claims 13 to 15, further comprising the step of causing said low doped or non-intentionally doped layer to have a dopant concentration of <1x10¹⁶ atoms/cm³.

17. The method of any of claims 13 to 16, further comprising the step of doping said highly doped layer to have a dopant concentration of >1x10¹⁷ atoms/cm³.

18. The method of any of claims 13 to 17, further comprising the step of forming said bipolar transistor to be a heterojunction bipolar transistor (HBT).

19. The method of any of claims 13 to 18, further comprising the step of forming said layers of GaAs.

20. The method of any of claims 13 to 18, further comprising the step of forming said base layer of GaAs, said low doped or non-intentionally doped layer of AlₓGa₁₋ₓAs, and said highly doped layer is graded from GaAs at its interface with said base layer to AlₓGa₁₋ₓAs as its interface with said low doped or non-intentionally doped layer.

21. The method of any of claims 13 to 20, further comprising the steps of:
forming a substrate;
depositing a subcollector layer on said substrate;
depositing said first collector layer on said subcollector layer,
depositing a base layer on said second collector layer; and
depositing an emitter layer on said base layer.

22. The method of Claim 21, further comprising the step of forming said emitter layer of semiconductor material having a wider energy bandgap than said base layer.

23. The method of any of claims 13 to 22, wherein said depositing is epitaxial depositing.
